# EUROPEAN PATENT APPLICATION

(11) **EP 1 566 837 A2**
(43) Date of publication of application: **24.08.2005**
(21) Application number: 05011683.9
(22) Date of filing: 13.04.2000
(51) Int. Cl.: H01L 21/768

(54) **Semiconductor device manufacturing method**

(30) Priority: 07.02.2000 JP 2000029387
(62) Divisional of application: 00107914.4
(71) Applicant: CANON SALES CO., INC., Tokyo 108-0073 (JP); SEMICONDUCTOR PROCESS LABORATORY CO., LTD., Chiba 272-0001 (JP)
(72) Inventor: Suzuki, Tomomi, Minato-ku Tokyo 108-0073 (JP); Ikakura, Hiroshi, Minato-ku Tokyo 108-0073 (JP); Maeda, Kazuo, Minato-ku Tokyo 108-0075 (JP); Shioya, Yoshimi, Minato-ku Tokyo 108-0075 (JP); Ohira, Koichi, Minato-ku Tokyo 108-0075 (JP)
(74) Representative: Schwabe - Sandmair - Marx

(57) **Abstract**

The present invention relates to a semiconductor device manufacturing method for forming a via hole or a contact hole in an interlayer insulating film with a low dielectric constant. The method comprises the steps of forming an underlying insulating film 2 formed of a nitrogen containing insulating film on a substrate 1, forming a porous insulating film 3 on the underlying insulating film 2, forming an opening portion 7a in the underlying insulating film 2 and the porous insulating film 3, and forming a nitrogen containing insulating film 4, 4a on a surface of the porous insulating film 3 and an inner surface of the opening portion 7a by bringing the surface of the porous insulating film 3 and the inner surface of the opening portion 7a into contact with any one gas plasma of an ammonia gas, a nitrogen gas, and an oxygen nitride gas.

## Description

### BACKGROUND OF THE INVENTION

### 1. Field of the Invention

The present invention relates to a semiconductor device manufacturing method for forming a via hole or a contact hole in an interlayer insulating film with a low dielectric constant.

### 2. Description of the Prior Art

In recent years, according to the higher integration degree and the higher density of the semiconductor integrated circuit device, the increase in the data transfer rate is requested. Therefore, wiring material is being changed from the conventional aluminum (Al) to copper (Cu) having low resistance.

In addition, concerning the interlayer insulating film to surround this wiring, the film with the low dielectric constant is now requested instead of the conventional SiO₂ film (dielectric constant 4.0). For example, the porous SiO₂ film whose dielectric constant is reduced at less than 2.0 can be formed now.

However, since the porous SiO₂ film formed by the film forming method in the prior art has porous property, it absorbs the moisture when it is left in the air, or it absorbs the moisture when it is subjected to the washing process after the film formation. As a result, there is such a problem that the dielectric constant is increased.

In particular, if the contact hole or the via hole is formed, sometimes the moisture is absorbed from the side wall of the opening portion such as the contact hole, etc.

Further, there is another problem that the moisture penetrates to the interlayer insulating film to cause the corrosion of the underlying wiring layer.

### SUMMARY OF THE INVENTION

It is an object of the present invention to provide a semiconductor device manufacturing method capable of preventing increase in the dielectric constant of the interlayer insulating film by suppressing the moisture absorption of the interlayer insulating film even when the interlayer insulating film with the low dielectric constant is formed and then the via hole or the contact hole is formed in the interlayer insulating film.

In the semiconductor device manufacturing method according to the present invention, the interlayer insulating film which comprises a multilayered structure such that the porous insulating film is formed on the underlying insulating film formed of the nitrogen containing insulating film, or the underlying insulating film formed of any one of the SiOC containing insulating film, the SiOCH containing insulating film, and the SiOCHN containing insulating film, and then the opening portion is formed in the interlayer insulating film.

The porous insulating film is quite suitable for the interlayer insulating film because it has the low dielectric constant, whereas the corrosion of the wiring is ready to occur if the porous insulating film is directly formed on the wiring, etc. because it has the high moisture penetration. In the invention of this application, the underlying insulating film formed of the nitrogen containing insulating film, or the underlying insulating film formed of any one of the SiOC containing insulating film, the SiOCH containing insulating film, and the SiOCHN containing insulating film is provided under the porous insulating film. Therefore, since the penetration of the moisture can be suppressed by the underlying insulating film, the corrosion of the wiring, etc. can be prevented.

In addition, after the step of forming the opening portion in the porous insulating film, the nitrogen containing insulating film is formed on the surface of the porous insulating film and the inner surface of the opening portion by bringing the exposed surface into contact with any one gas plasma of the ammonia gas, the nitrogen gas, and the oxygen nitride gas.

Accordingly, since the overall surface of the interlayer insulating film is covered with the nitrogen containing insulating films, the penetration of the moisture into the interlayer insulating film can be further suppressed.

Also, after the step of forming the opening portion in the porous insulating film, the opening portion is exposed to the CₓHy gas plasma. Accordingly, since the cover insulating film formed of the hydrocarbon layer containing CₓHy, e.g., CH₃ can be formed on the surface of the porous insulating film containing the inner surface (especially, side wall) of the opening portion, the improvement of the moisture resistance can be attained.

### BRIEF DESCRIPTION OF THE DRAWINGS

FIGS.1A to 1G are sectional views showing a semiconductor device manufacturing method according to a first embodiment of the present invention;
FIGS.2A to 2F are sectional views showing a semiconductor device manufacturing method according to a second embodiment of the present invention; and
FIG.3 is a sectional view showing a semiconductor device manufacturing method according to a third embodiment of the present invention.

### DESCRIPTION OF THE PREFERRED EMBODIMENTS

Embodiments of the present invention will be explained with reference to the accompanying drawings hereinafter.

### (First Embodiment)

FIGS.1A to 1G are sectional views showing a semiconductor device manufacturing method according to a first embodiment of the present invention.

To begin with, a silicon substrate 1 is loaded in the pressure-reducible chamber, then the silicon substrate 1 is placed on a substrate holding table which is commonly used as a lower electrode of the parallel plate type electrode, and then heated up to 300 °C . While maintaining this temperature and introducing into the chamber a mixed gas of SiH₄ whose flow rate is about 50 SCCM and NH₃ whose flow rate is about 250 SCCM, a gas pressure in the chamber is set to 0.5 Torr.

Then, a power 100 W of a frequency 400 kHz is applied to a lower electrode on which the silicon substrate 1 is held, and a power 50 W of a frequency 13.56 MHz is applied to an upper electrode that opposes to the lower electrode. Thus, the mixed gas of SiH₄ and NH₃ can be plasmanized. While holding this condition, as shown in FIG.1A, an SiN film (nitrogen containing insulating film) 12 is formed on the silicon substrate 1 by the plasma CVD method. The SiN film 2 means an insulating film which consists only of silicon (Si) and nitrogen (N).

An SiON film may be employed in lieu of the SiN film 2. In case the SiON film is formed, an N₂O gas is further added to the mixed gas of SiH₄ and NH₃. A flow rate of the N₂O gas is set to 20 SCCM, for example, if a flow rate of the SiH₄ is set to about 50 SCCM and a flow rate of the NH₃ is set to about 250 SCCM.

Then, while heating the silicon substrate 1 at 300 °C and introducing into the chamber the mixed gas of (CH₃)₃SiOSi(CH₃) whose flow rate is about 50 SCCM and O₂ whose flow rate is about 25 SCCM, the gas pressure is set to 2 Torr. Then, the power 100 W of the frequency 400 kHz is applied to the lower electrode, and the power 50 W of the frequency 13.56 MHz kHz is applied to the upper electrode. Thus, the mixed gas of (CH₃)₃SiOSi(CH₃)₃ and O₂ can be plasmanized. While holding this condition, as shown in FIG.1B, an SiOCH film 3 of about 400 nm thickness is formed on the SiN film 2 by the plasma CVD method. The SiOCH film 3 means an insulating film which consists only of silicon (Si), oxygen (O), carbon (C), and hydrogen (H).

Then, under the condition that silicon substrate 1 is heated at 400 °C, O₂ at a flow rate of about 25 SCCM is introduced into the chamber while the gas pressure is set to 0.4 Torr. Then, the power 100 W of the frequency 400 kHz is applied to the lower electrode. Thus, O₂ is plasmanized. If this condition is held, the carbon in the SiOCH film 3 and the incoming oxygen react with each other to form voids in the SiOCH film 3, so that the SiOCH film 3 having a number of voids is formed. In the following, sometimes the SiOCH film 3 having a number of voids is called a porous SiOCH film.

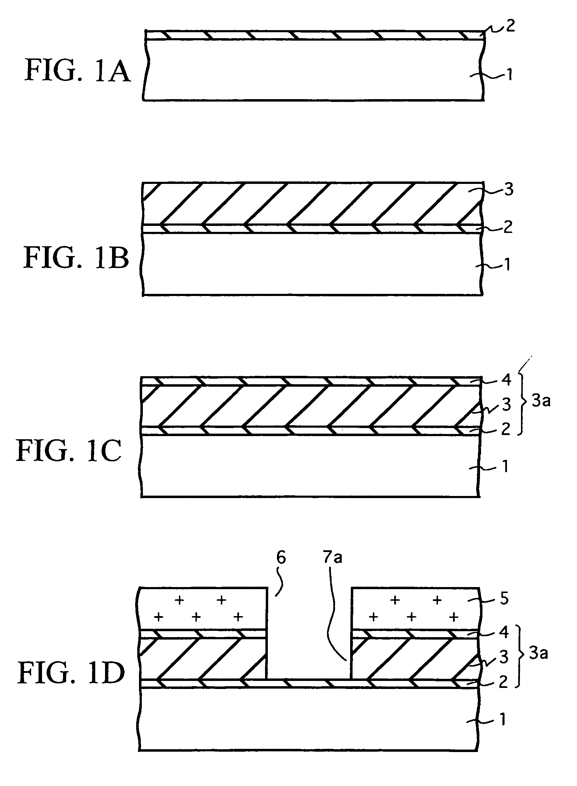

Then, under the condition that the silicon substrate 1 is heated at 400 °C, NH₃ at a flow rate of about 25 SCCM is introduced into the chamber while the gas pressure is set to 0.4 Torr. Then, the power 400 W of the frequency 400 kHz is applied to the lower electrode. Hence, as shown in FIG.1C, NH₃ is plasmanized. A nitrogen containing insulating film (cover insulating film) 4 is formed on a surface layer of the SiOCH film 3 by holding this condition. The SiN film 2, the SiOCH film 3, and the nitrogen containing insulating film 4 constitute as a whole an interlayer insulating film 3a. In the following, sometimes the interlayer insulating film containing the porous SiOCH film is called a porous interlayer insulating film.

Then, a photoresist film 5 is formed on the porous interlayer insulating film 3a, and then an opening portion 6 of the photoresist film 5 is formed in a region, in which a contact hole of the interlayer insulating film 3a is to be formed, by patterning the photoresist film 5.

Then, as shown in FIG.1D, by the plasma etching method using a mixed gas of CF₄, CHF₃, and O₂, an opening portion 7a is formed in the nitrogen containing insulating film 4 and the porous interlayer insulating film 3 out of the porous interlayer insulating film 3a via the opening portion 6 in the photoresist film 5.

Then, as shown in FIG.1E, the photoresist film 5 is removed by ashing using O₂, and then residue of the photoresist film 5 is removed by the chemicals process.

Then, as shown in FIG.1F, NH₃ at a flow rate of about 400 SCCM is introduced into the chamber while the gas pressure is set to 0.2 Torr. Then, the power 300 W of the frequency 400 kHz is applied to the lower electrode. Hence, NH₃ is plasmanized. While holding this condition, as shown in FIG.1F, the nitrogen containing insulating film (cover insulating film) 4, 4a is formed on a surface layer of the interlayer insulating film 3a containing the inner wall of the opening portion 7a. The nitrogen containing insulating film 4, 4a may be formed under the same condition by using N₂ in place of NH₃.

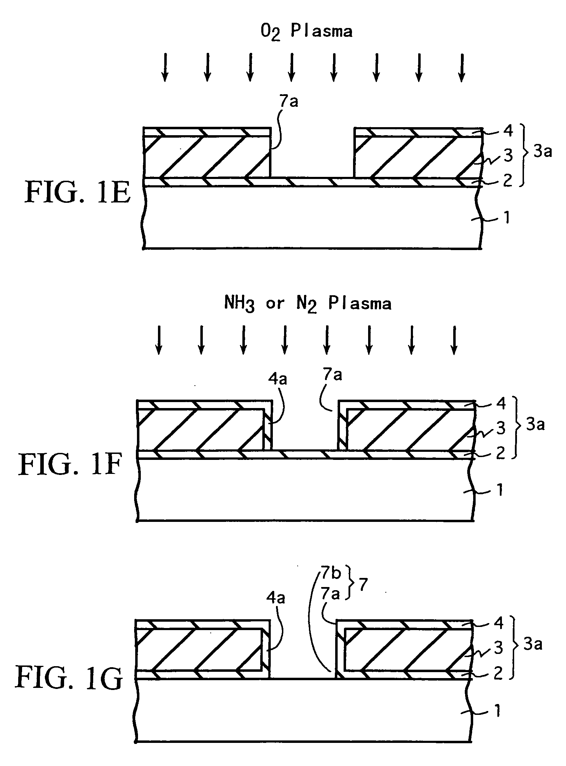

Then, as shown in FIG.1G, the SiN film 2 exposed on the bottom of the opening portion 7a is removed by the anisotropic etching using a mixed gas of Cl₂, O₂, and CF₄ to form an opening portion 7b. Thus, the silicon substrate 1 comes out on the bottom of the new opening portion 7.

After this, a wiring metal film (not shown) is formed and then the upper wiring layer is formed by patterning the wiring metal film.

As stated above, according to the first embodiment, the porous interlayer insulating film 3a in which the porous SiOCH film 3 is sandwiched by the nitrogen containing insulating film 4 and the underlying insulating film 2 formed of the SiN film respectively is formed, and then the opening portion 7 is formed in the porous interlayer insulating film 3a.

That is, the underlying insulating film 2 formed of the SiN film is provided under the porous SiOCH film 3. Accordingly, the penetration of the moisture can be suppressed by the underlying insulating film 2, therefore penetration of the moisture into the lower area of the porous interlayer insulating film 3a can be prevented. Thus, for example, the corrosion of the lower wiring, etc. can be prevented.

Then, as shown in FIG.1E, after the step of forming the opening portion 7a in the porous interlayer insulating film 3a, SiN films 4, 4a are formed on the surface of the porous interlayer insulating film 3a and the side wall of the opening portion 7a respectively by bringing the exposed surface into contact with the ammonia gas plasma.

Accordingly, the overall surface of the porous interlayer insulating film 3a containing the opening portion 7a is covered with the SiN films 4, 4a, therefore the penetration of the moisture into the porous interlayer insulating film 3a and the lower area thereof can be much more suppressed.

As described above, since improvement of the moisture resistance of the porous interlayer insulating film 3a can be achieved, the good contact resistance between the upper and lower wirings-electrodes, etc. can be obtained without the degradation of the low dielectric constant characteristic. As a result, the present invention is effective as the method of forming the contact hole in the porous interlayer insulating film 3a in the high-speed logic semiconductor integrated circuit, and has a remarkable effect on the higher operation speed due to the lower dielectric constant of the interlayer insulating film.

### (Second Embodiment)

FIGS.2A to 2F are sectional views showing a semiconductor device manufacturing method according to a second embodiment of the present invention.

It is different from the first embodiment that the SiOCH film is employed as the underlying insulating film 12 in place of the SiN film and that a hydrocarbon layer (a hydrocarbon containing insulating film; a cover insulating film) 17 containing CₓH_{y}, e.g., CH₃ is formed on a surface layer of a porous interlayer insulating film 13 containing an inner wall of an opening portion 16a. A manufacturing method thereof will be explained in the following.

First, a wafer 11 is loaded in the pressure-reducible chamber, then the wafer 11 is placed on a substrate holding table which is commonly used as the lower electrode of the parallel plate type electrode, and then heated up to 300 °C. Assume that a silicon substrate is appeared from the surface of the wafer.

While maintaining this substrate heating temperature and introducing a mixed gas of (CH₃)₃SiOSi(CH₃)₃ whose flow rate is about 50 SCCM and O₂ whose flow rate is about 25 SCCM, the gas pressure is set to 2 Torr.

Then, the power 100 W of the frequency 400 kHz is applied to the lower electrode, and the power 50 W of the frequency 13.56 MHz is applied to the upper electrode that opposes to the lower electrode. Thus, (CH₃)₃SiOSi(CH₃)₃ and O₂ can be plasmanized. While holding this condition, as shown in FIG.2A, an SiOCH film 12 of about 20 nm thickness is formed on the silicon substrate on the wafer 11 by the plasma CVD method. The SiOCH film 12 means an insulating film which contains only silicon (Si), oxygen (O), carbon (C), and hydrogen (H).

Then, while heating the wafer 11 at the temperature 300 °Cand introducing into the chamber the mixed gas of (CH₃)₃SiOSi(CH₃)₃ whose flow rate is about 50 SCCM and O₂ whose flow rate is about 25 SCCM, the gas pressure is set to 2 Torr. Then, the power 100 W of the frequency 400 kHz is applied to the lower electrode, and the power 50 W of the frequency 13.56 MHz kHz is applied to the upper electrode which faces to the lower electrode. As a result, the mixed gas of (CH₃)₃SiOSi(CH₃)₃ and O₂ can be plasmanized. While holding this condition, as shown in FIG.2B, the SiOCH film 13 of about 400 nm thickness is formed on the SiOCH film 12 by the plasma CVD method.

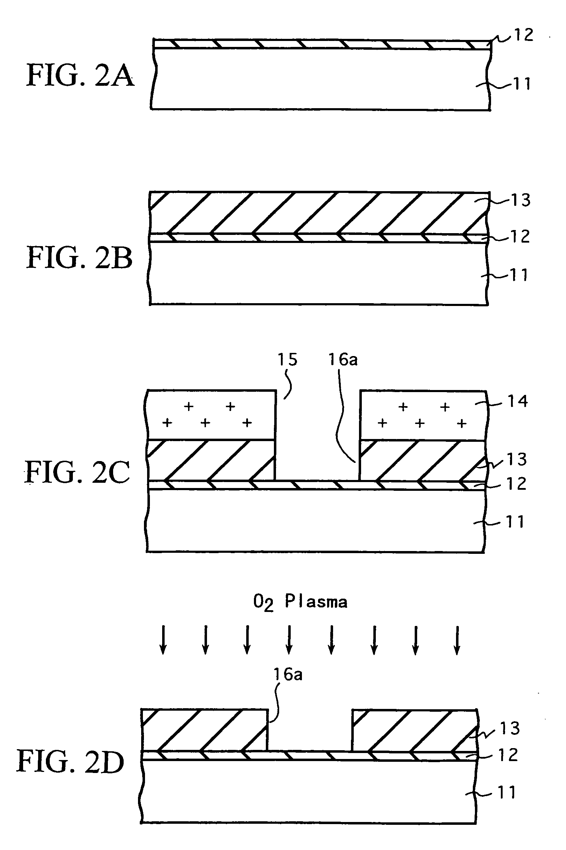

Then, a photoresist film 14 is formed on the SiOCH film 13 and then an opening portion 15 of the photoresist film 14 is formed in a region, in which a contact hole of the SiOCH film 13 is to be formed, by patterning the photoresist film 14. Then, as shown in FIG.2C, an opening portion 16a is formed in the SiOCH film 13 via the opening portion 15 in the photoresist film 14 by the plasma etching method using the mixed gas of CF₄, CHF₃, and O₂.

Then, the photoresist film 14 is removed by ashing using O₂, and then residue of the photoresist film 14 is removed by the chemicals process.

Then, while heating the wafer 11 at 400 °C and introducing O₂ at a flow rate of about 25 SCCM, the gas pressure is set to 0.4 Torr. Then, the power 400 W of the frequency 400 kHz is applied to the lower electrode. Hence, O₂ is plasmanized. As shown in FIG.2D, if this condition is held, the carbon in the SiOCH film 13 and the incoming oxygen react with each other to remove the carbon and therefore voids are formed in the film. Therefore, the porous SiOCH film 13 is formed.

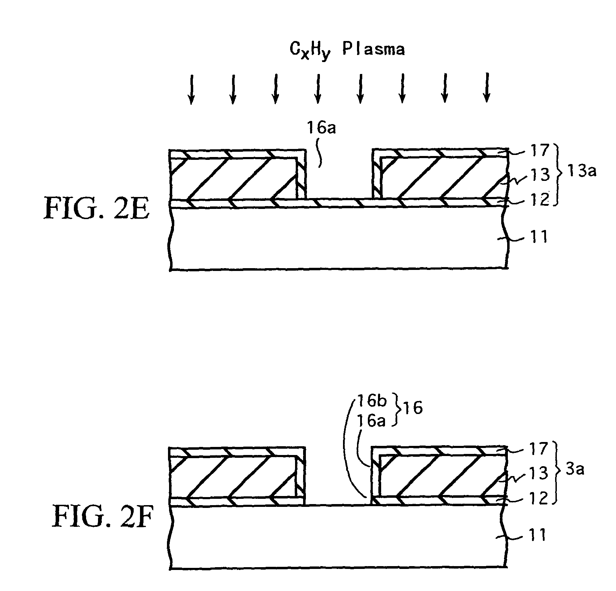

Then, as shown in FIG.2E, the wafer 11 is heated at 400 °C, and CₓH_{y} at a flow rate of about 100 SCCM is introduced into the chamber while the gas pressure is set to about 0.4 Torr. Then, the power 400 W of the frequency 400 kHz is applied to the lower electrode to plasmanize CₓH_{y}. While holding this condition, as shown in FIG.2E, the hydrocarbon layer (cover insulating film) 17 containing CₓH_{y} is formed on the porous SiOCH film containing the inner wall of the opening portion 16a. The SiOCH film 12, the porous SiOCH film 13, and the hydrocarbon film 17 constitute as a whole a porous interlayer insulating film 13a.

Then, as shown in FIG.2F, the SiOCH film 12 exposed on the bottom of the opening portion 16a is removed by the anisotropic etching using a mixed gas of CF₄, CHF₃, and O₂ to form an opening portion 16b. Thus, the silicon substrate 11 comes into appearance on the bottom of the new opening portion 16.

After this, the wiring metal film (not shown) is formed and then the upper wiring layer is formed by patterning the wiring metal film.

As mentioned above, in the semiconductor device manufacturing method according to the present invention, the porous SiOCH film 13 is formed on the underlying insulating film 12 made of the SiOCH film, and then the opening portion 16a is formed in the porous SiOCH film 13.

Since the penetration of the moisture into the lower layer can be suppressed by the underlying insulating film 12, sticking of the contaminant onto the silicon substrate, the corrosion of the electrode on the surface of the silicon substrate, etc. can be prevented.

In addition, after the step of forming the opening portion 16a in the porous SiOCH film 13, the opening portion 16a is exposed to the CₓH_{y} gas plasma. Accordingly, the hydrocarbon layer 17 containing CₓH_{y} can be formed on the surface of the porous SiOCH film 13 containing the inner wall of the opening portion 16a, thus improvement of the moisture resistance can be attained.

In this case, like the first embodiment, since the improvement of the moisture resistance of the porous interlayer insulating film 13a can be achieved, the good contact resistance between the upper and lower wirings-electrodes, etc. can be obtained without the degradation of the low dielectric constant characteristic. As a result, the present invention is effective as the method of forming the contact hole in the porous interlayer insulating film 3a in the high-speed logic semiconductor integrated circuit, and has a remarkable effect on the higher operation speed due to the lower dielectric constant of the interlayer insulating film.

### (Third Embodiment)

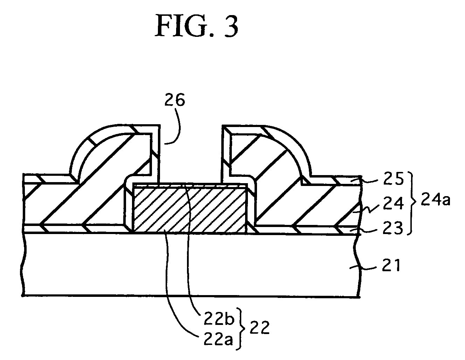

FIG.3 is a sectional view showing a semiconductor device manufacturing method according to a third embodiment of the present invention.

A difference from the first and second embodiments is that a lower wiring (the conductive substrate) 22 consisting of an Al film 22a and a Ti film 22b on the Al film 22a is formed on a lower insulating film 21 which is formed on the silicon substrate of the wafer.

FIG.3 is a sectional shape after a porous interlayer insulating film 24a and an opening portion 26 on the lower wiring 22 are formed by applying the present invention to the wafer. In FIG.3, 23 denotes an underlying insulating film formed of the same material as that in the first or second embodiment; 24, a porous insulating film formed of the same material as that in the first or second embodiment; and 25, a cover insulating film formed of the same material as that in the first or second embodiment.

In the case of the third embodiment, because the penetration of the moisture into the porous interlayer insulating film 24a and the lower area thereof can be suppressed by the underlying insulating film 23 and the cover insulating film 25, the corrosion of the lower wiring 22 can be prevented.

In this case, like the first embodiment, since the improvement of the moisture resistance of the porous interlayer insulating film 24a can be achieved, the good contact resistance between the upper and lower wiring layers can be obtained without the degradation of the low dielectric constant characteristic. As a result, the present invention is effective as the method of forming the contact hole in the interlayer insulating film 24a in the high-speed logic semiconductor integrated circuit, and has a remarkable effect on the higher operation speed due to the lower dielectric constant of the interlayer insulating film 24a.

Although the present invention has been explained in detail with reference to the embodiment, the scope of the present invention is not restricted to examples shown concretely in the above embodiments. Various modifications of the above embodiments may be included in the scope of the present invention without departing from the gist of the present invention.

For example, the SiN film 2 is provided under the porous SiOCH film 3 in the first embodiment, but other insulating film such as the SiON film or the SiOCH film may be provided. The SiOCH film 12 is provided under the porous SiOCH film 13 in the second embodiment, but other insulating film such as the SiN film or the SiON film may be provided. In addition, in the first and second embodiments, the underlying insulating film formed of any one of an SiOC film and an SiOCHN film may be provided in lieu of these underlying insulating films. Here the SiOC film means an insulating film containing only Si, O, C, and H, and the SiOCHN film means an insulating film containing only Si, O, C, H, and N. In this case, the SiOC film can be formed by the plasma CVD method using (CH₃)₃SiOSi(CH₃)₃ whose flow rate is 50 SCCM under the condition that the gas pressure is adjusted to 1 Torr and the power 200 W of the frequency 400 kHz is applied to the lower electrode. And the SiOCHN film can be formed by the plasma CVD method using a gas in which a very small amount of N₂O is added to the SiOCH film forming gas, i.e., the mixed gas of (CH₃)₃SiOSi(CH₃)₃ and O₂.

In addition, in the first embodiment, after the step of forming the opening portion 7a in the porous interlayer insulating film 3a, the nitrogen containing insulating films 4, 4a are formed on the surface of the porous interlayer insulating film 3a containing the side wall of the opening portion 7a respectively by bringing the exposed surface into contact with the ammonia gas. In this case, the exposed surface may be brought into contact with any one of a nitrogen gas and an oxygen dinitride gas in place of the ammonia gas.

Also, as shown in FIG.1E, after the resist film 5 has been removed, the inner wall of the opening portion 7a is brought into contact with the nitrogen containing gas such as the ammonia gas, etc. Alternatively, the inner wall of the opening portion 7a may be brought into contact with the nitrogen containing gas such as the ammonia gas, etc. while leaving the resist film 5. The processing conditions may be set similarly to the case where the resist film is removed.

Although the porous insulating film 3 has already been covered with the nitrogen containing insulating film 4 before the exposed surface is brought into contact with the ammonia gas, the nitrogen containing insulating film 4 is not formed before contact with the ammonia gas. In this case, the surface of the porous insulating film 3 is brought into direct contact with the ammonia gas to form the nitrogen containing insulating film 4 on the surface of the porous insulating film 3 while forming the nitrogen while forming the nitrogen containing insulating film 4a on the inner surface of the opening portion 7a.

Also, in the above embodiments, the porous SiOCH film is employed as the porous insulating films 3, 13, 24. Alternatively, any one of the porous SiOC film and the porous SiOCHN film may be employed.

As described above, according to the present invention, the porous interlayer insulating film which contains the porous insulating film is formed on the underlying insulating film which is formed of any one of the nitrogen containing insulating film, the SiOC containing insulating film, the SiOCH containing insulating film, and the SiOCHN containing insulating film, and then the opening portion is formed in the porous interlayer insulating film.

Since the penetration of the moisture can be suppressed by the underlying insulating film 2, the corrosion of the wiring, etc. can be prevented.

In addition, after the step of forming the opening portion in the porous interlayer insulating film, the nitrogen containing insulating films are formed on the surface of the interlayer insulating film and the side wall of the opening portion by bringing the exposed surface into contact with any one gas plasma of the ammonia gas, the nitrogen gas, and the oxygen nitride gas.

Accordingly, the overall surface of the porous interlayer insulating film is covered with the nitrogen containing insulating films, therefore the penetration of the moisture into the porous interlayer insulating film can be further suppressed.

Also, after the step of forming the opening portion in the porous interlayer insulating film, the opening portion is exposed to the CₓH_{y} gas plasma. Accordingly, the hydrocarbon layer containing CₓH_{y} can be formed on the surface of the porous interlayer insulating film containing the inner wall of the opening portion, thus the improvement of the moisture resistance can be attained.

As mentioned above, since the improvement of the moisture resistance of the porous interlayer insulating film can be achieved, the good contact resistance between the upper and lower wiring layers can be obtained without the degradation of the low dielectric constant characteristic. As a result, the present invention is effective as the method of forming the contact hole in the interlayer insulating film in the high-speed logic semiconductor integrated circuit, and has a remarkable effect on the higher operation speed due to the lower dielectric constant of the interlayer insulating film.

## Claims

1. A semiconductor device manufacturing method comprising the steps of:
forming an underlying insulating film (2, 12) made of any one of an SiOC containing insulating film, an SiOCH containing insulating film, and an SiOCHN containing insulating film on a conductive substrate (1,(11);
forming a porous insulating film (3, 13) on the underlying insulating film (2, 12); and
forming an opening portion (7, 16) in an interlayer insulating film (3a, 13a) containing the underlying insulating film (2, 12) and the porous insulating film (3, 13).

2. A semiconductor device manufacturing method according to claim 1, wherein the interlayer insulating film (3a, 13a) contains any one of a nitrogen containing insulating film (4) and a hydrocarbon containing insulating film (17) formed on the porous insulating film (3, 13), in addition to the underlying insulating film (2, 12) and the porous insulating film (3, 13).

3. A semiconductor device manufacturing method according to claim 1, wherein the step of forming the opening portion (7) in an interlayer insulating film (3a) comprises the steps of:
forming a nitrogen containing insulating film (4) on a surface of the porous insulating film (3);
forming an opening portion (7a) in the nitrogen containing insulating film (4) and the porous insulating film (3); and
forming a nitrogen containing insulating film (4, 4a) on a surface of the porous insulating film (3) and an inner surface of the opening portion (7a) by bringing the surface of the nitrogen containing insulating film (4) and the inner surface of the opening portion (7a) into contact with any one gas plasma of an ammonia gas, a nitrogen gas, and an oxygen nitride gas.

4. A semiconductor device manufacturing method according to claim 3, after the step of forming the nitrogen containing insulating film (4, 4a), further comprising the step of:
forming an opening portion (7b) in the underlying insulating film (2) to expose the substrate (1).

5. A semiconductor device manufacturing method according to claim 1, wherein the step of forming the opening portion (16) in an interlayer insulating film (13a) comprises the steps of:
forming an opening portion (16a) in the porous insulating film (13); and
forming a hydrocarbon containing insulating film (17) on a surface of the porous insulating film (13) and an inner surface of the opening portion (16a) by bringing the surface of the porous insulating film (13) and the inner surface of the opening portion (16a) into contact with a CxHy gas plasma.

6. A semiconductor device manufacturing method according to claim 5, after the step of bringing into contact with the CxHy gas plasma, further comprising the step of:
removing the CxHy remaining in the opening portion (16a) by using an 02 plasma or an 02 + CF4 gas plasma.

7. A semiconductor device manufacturing method according to claim 6, after the step of removing the CxHy, further comprising the step of:
forming an opening portion (16b) in the underlying insulating film (12) to expose the substrate (11).

8. A semiconductor device manufacturing method according to claims 1, wherein the conductive substrate (1, 11) is a metal wiring (22).
